# DEMANDE DE BREVET EUROPEEN

(11) **EP 0 847 082 A2**
(43) Date de publication de la demande: **10.06.1998**
(21) Numéro de dépôt: 97402892.0
(22) Date de dépôt: 02.12.1997
(51) Int. Cl.: H01L 21/306, C23C 16/02, H01L 21/768

(54) **Procédé de traitement d'un substrat semi-conducteur comprenant une étape de traitement de surface**

(30) Priorité: 04.12.1996 FR 9614875
(71) Demandeur: FRANCE TELECOM, 75015 Paris (FR)
(72) Inventeur: Berenguer, Marc, 38420 Revel (FR); Pons, Michel, 38240 Meylan (FR)
(74) Mandataire: Casalonga, Axel

(57) **Abrégé**

L'invention a trait à un procédé de traitement d'un substrat semiconducteur comprenant une étape préalable de traitement de surface par un plasma, à moyenne ou basse pression, ayant de préférence une concentration en électrons nₑ ≥ 10¹¹ cm⁻³ et produisant de préférence une différence de potentiel faible Vₚ - V_{f} < 20 V. L'énergie de la surface traitée est ensuite déterminée afin éventuellement de rétroagir rapidement sur le réglage du procédé pour optimiser le traitement par plasma. L'étape préalable de traitement de surface peut être suivie d'une étape de dépôt en vue notamment du remplissage et/ou de l'aplanissement de la surface traitée.

## Description

La présente invention a trait à un procédé de traitement d'un substrat semi-conducteur dans la réalisation de circuits intégrés.

L'augmentation de la densité d'intégration et de la rapidité des circuits intégrés conduit à une réduction régulière de la taille des transistors élémentaires les composant. En fait, l'évolution des technologies de fabrication est en particulier caractérisée par une diminution des dimensions latérales qui s'effectue plus vite au cours du temps que celle des dimensions verticales (par exemple les largeurs minimales des motifs photogravés sont réduites à un rythme plus rapide que les épaisseurs typiques des couches déposées). Dans certains cas, il en résulte une augmentation importante des facteurs de forme (rapport profondeur/largeur d'un motif) par rapport aux technologies de génération antérieure et donc un relief tourmenté.

Par ailleurs, des dépôts réalisés sur de telles surfaces non planes interviennent dans certaines étapes de fabrication de circuits intégrés. Parmi celles-ci, on peut mentionner les techniques d'isolation latérale qui nécessitent de déposer une ou plusieurs couches diélectriques dans des tranchées gravées dans le silicium, ainsi que les techniques d'isolation intermétallique.

Du fait du relief tourmenté de la surface recevant le dépôt, des défauts morphologiques peuvent apparaître dans ces couches déposées. On peut citer principalement des effets de cavités, des effets de craquelures et des effets de vagues (variations périodiques ou pseudo-périodiques de l'épaisseur sur des distances importantes).

Il convient donc de trouver des procédés de dépôt surmontant ces inconvénients liés notamment à la géométrie des motifs sous-jacents et aux caractéristiques physiques propres des matériaux déposés.

Les inventeurs ont mis au point un procédé de traitement d'un substrat semi-conducteur comprenant une étape préalable de traitement de surface qui, dans le cas précis d'opérations de dépôts de la tcchnique d'isolation latérale ou la technique d'isolation intermétallique ou de tout autre structure réalisant des fonctions similaires, permet de diminuer voire de faire disparaître les défauts morphologiques de type craquelures, cavités ou vagues, tout en maintenant ou en améliorant les caractéristiques morphologiques, physiques et électriques du matériau déposé.

Le procédé de traitement selon l'invention agit sur l'état physique des surfaces sur lesquelles sont effectués les dépôts. Cet état est caractérisé par l'énergie de surface, énergie qui peut évoluer au cours du temps, par exemple en fonction d'éventuelles pollutions. Du point de vue théorique, les énergies de surface interviennent par exemple dans l'expression du travail d'adhésion d'un liquide sur une surface solide. Ce travail peut également être donné par l'équation de Young-Dupré qui fait intervenir l'énergie superficielle du liquide et l'angle de contact de la goutte de liquide sur le solide.

Le procédé de traitement selon l'invention permet plus particulièrement de stabiliser la surface pilotant la structure du dépôt en faisant en sorte que l'énergie de surface soit uniforme et reproductible.

Ainsi, l'invention a pour objet le procédé de traitement d'un substrat semi-conducteur qui comprend préalablement une étape de traitement de surface comprenant les étapes suivantes :
a) le prétraitement de la surface par un plasma, à moyenne ou basse pression;
b) la détermination de l'énergie de surface de la surface ainsi traitée; et
c) la réitération éventuelle de l'étape a) suivant les résultats obtenus dans l'étape b).

Les précurseurs gazeux utilisés pour le plasma de l'étape a) sont principalement l'azote, l'oxygène, l'oxyde d'azote, l'hydrogène, l'argon, le silane, ainsi que des mélanges de ces gaz. Ceux-ci s'avèrent en effet produire des atomes ou des radicaux capables de modifier l'énergie de surface avec une gamme d'effets très étendue.

L'étape de prétraitement de surface selon l'invention peut s'effectuer dans tout type de réacteur approprié.

Selon une mise en oeuvre préférentielle du procédé de l'invention, on réalise le traitement de surface dans une source à forte densité de plasma et donc à forte densité d'espèce active avec nₑ ≥ 10¹¹ cm⁻³. En effet, l'utilisation d'un tel réacteur permet un traitement de surface efficace avec une durée très réduite égale ou inférieure à 2 minutes.

Selon un autre aspect préférentiel de l'étape a), on effectue le prétraitement de la surface en instaurant une différence de potentiel (potentiel plasma potentiel flottant) faible, notamment Vₚ - V_{f} < 20 V.

Dans l'étape b), la détermination de l'énergie de surface de la surface prétraitée est de préférence effectuée par une méthode de caractérisation sensible et rapide telle que la mesure de l'angle de contact d'une goutte de liquide sur la surface, méthode par ailleurs simple et non destructive qui permet une rétroaction rapide pour le réglage de l'étape de prétraitement.

Le procédé de traitement selon l'invention est particulièrement indiqué lorsque la surface du semi-conducteur à traiter n'est pas plane et présente des facteurs de forme compris typiquement entre 2 et 6.

Le procédé de traitement comprend, selon un premier mode de réalisation de l'invention, outre l'étape de traitement de surface, au moins une étape de dépôt en vue du remplissage et/ou de l'aplanissement de la surface traitée. Si le procédé de traitement selon l'invention comporte plusieurs étapes de dépôt, ces étapes sont séparées l'une de l'autre par une réitération de l'étape préalable du traitement de surface décrit plus haut.

Selon une mise en oeuvre préférentielle de l'invention, l'étape préalable de traitement de surface et l'étape de dépôt sont réalisées au sein d'un même réacteur. Les réacteurs plasma les plus appropriés sont des sources basse pression à haute densité avec polarisation indépendante.

Selon un aspect de l'invention, le matériau déposé dans l'étape ultérieure du procédé de traitement de l'invention est un diélectrique déposé en vue de l'isolation latérale par tranchées de futures zones actives du substrat semi-conducteur ou en vue de l'isolation intermétallique.

Selon un autre aspect de l'invention, le matériau déposé est un matériau conducteur en vue de l'établissement d'interconnexions dans le substrat semi-conducteur. Comme dans le cas des diélectriques, l'effet attendu est une modification (amélioration) des caractéristiques physiques et plus particulièrement mécaniques du matériau, la mise au point du procédé étant effectuée de façon similaire.

D'autres types de dépôts peuvent être envisagés et comprennent le dépôt d'un matériau choisi parmi les diélectriques, les polymères déposés par plasma et des polysiloxanes en solution déposés à la tournette du type "spin on glass" (SOG).

Selon un autre mode de réalisation du procédé de l'invention, le traitement de surface est mis en oeuvre non pas directement en vue d'améliorer un dépôt ultérieur, mais par exemple en vue de l'amélioration de l'état physique d'une surface, par exemple pour transformer une couche SOG en un matériau proche de SiO₂, ou pour passiver la surface d'un dépôt aplanissant.

Selon un mode de réalisation préférentiel de l'invention, le procédé comprend plusieurs étapes de dépôt d'un diélectrique, de préférence l'oxyde de silicium, en vue du remplissage et de l'aplanissement d'une surface à motifs variables. Cette mise en oeuvre préférentielle du procédé de l'invention comprend la succession des étapes suivantes :
1. le traitement de surface préalable effectué sur un oxyde thermique formé dans les tranchées réalisées au sein du substrat semi-conducteur, avec un plasma de N₂O selon les étapes a) à c) décrites précédemment;
2. le dépôt par PECVD à pression réduite d'une première couche d'oxyde de silicium;
3. la réitération de l'étape 1;
4. le dépôt par CVD d'une couche d'oxyde de silicium d'aplanissement de type "APL";
5. le traitement de surface par plasma de O₂ selon les étapes a) à c) décrites précédemment;
6. la réitération de l'étape 1;
7. le dépôt par PECVD à pression réduite d'une couche d'oxyde de silicium dite d'encapsulation, la durée de ce dépôt étant supérieure à cclle du dépôt de l'étape 2.

Selon ce mode de réalisation préférentiel de l'invention, on obtient une structure de type BOX sans cavité ni effet de vague avec un degré d'aplanissement nettement augmenté.

D'autres avantages et caractéristiques de l'invention apparaîtront à l'examen de la description détaillée des modes de mise en oeuvre et de réalisation de l'invention, nullement limitatifs.

L'invention concerne un procédé de traitement de substrat semi-conducteur mis en oeuvre au cours de la fabrication de circuits intégrés. Ce procédé de traitement comprend, préalablement, une étape de traitement de surface avantageusement mis en oeuvre avant un dépôt sur la surface traitée. Cette étape de traitement de surface du substrat semi-conducteur permet de modifier les différentes composantes polaire, apolaire et topographique de l'énergie de surface qui caractérise l'état physique microscopique de ladite surface. Il est ainsi possible de déterminer les conditions pour lesquelles l'énergie de surface est reproductible et uniforme sur la surface traitée. Cette stabilisation de la surface permet d'améliorer très sensiblement les caractéristiques morphologiques et topographiques d'un dépôt effectué après le traitement de surface et en outre permet de maintenir ou d'améliorer les caractéristiques électriques du matériau déposé.

La surface traitée peut être de différentes natures. Il peut s'agir du substrat semi-conducteur tel que du silicium ou un alliage à base de silicium, d'un matériau diélectrique et notamment de l'oxyde de silicium, tel qu'un oxyde thermique ou un oxyde déposé par CVD ou PECVD, ou un métal notamment en vue de l'établissement d'interconnexion au sein du substrat semi-conducteur, ou un polymère tel qu'un polysiloxane SOG.

Le traitement de surface s'effectue généralement en deux étapes, voire trois ou plus. Les étapes principales de ce procédé comprennent :
a) le prétraitement de la surface par un plasma, à basse ou moyenne pression.
   Par basse ou moyenne pression, on entend des pressions comprises entre 0,5 mTorr et 1000 mTorr. En fait le domaine de pression de fonctionnement du traitement de surface par plasma est directement lié aux types de réactcurs, ou sources plasma, utilisés. Ces domaines dc pressions ne diffèrent pas notablement de celles des procédés (dépôt, gravure) pour lesquels les réacteurs sont habituellement conçus. Certains réacteurs fonctionnent à moyenne pression, de l'ordre de 50 à 1000 mTorr, telle que par exemple une source de type diode RF habituellement utilisée pour le dépôt d'oxyde PECVD. Les sources de plasmas de génération plus récente (ECR, DECR, couplage inductif, helicon, etc...), habituellement utilisées aussi bien pour le dépôt que pour la gravure, constituent quant à eux des exemples de systèmes fonctionnant à basse pression, typiquement de l'ordre de 0,5 à 10 mTorr.
   Selon une mise en oeuvre préférentielle du procédé de l'invention, on effectue le prétraitement de surface dans une source de génération plus récente qui permet d'instaurer une forte densité de plasma, et donc une forte densité d'espèce active avec notamment une concentration d'électrons nₑ ≥ à 10¹¹ cm⁻³. En effet, ce type de source conduit à un traitement de surface efficace en une durée très réduite typiquement égale ou inférieure à 2 minutes.
   L'utilisation de réacteurs à faible densité, de génération plus ancienne, pour lesquels nₑ << 10¹¹ cm³, implique des traitements plus longs mais néanmoins envisageables dans le cadre de l'invention et compatibles avec des applications industrielles, en particulier lorsqu'on souhaite effectuer le traitement sur plusieurs échantillons à la fois (réacteurs à fournée).
   Ce traitement par plasma doit fournir une énergie de bombardement ionique la plus faible possible pour ne pas créer de défaut sur la surface traitée. C'est pourquoi on effectue de préférence le traitement de manière à produire une différence entre le potentiel plasma et le potentiel flottant faible, typiquement Vₚ - V_{f} < 20 V.
   On fixera avantageusement les composantes d'énergic de surface sur la surface traitée de façon uniforme, si le prétraitement est réalisé au potentiel flottant produisant ainsi une faible énergie de bombardement ionique puisqu'aucune polarisation électrique extérieure n'est appliquée à l'échantillon. Un tel traitement conduit à une transformation physico-chimique douce de la surface par greffage d'atomes ou par ouverture de liaisons polaires. Si l'on applique une polarisation importante, on augmente l'énergie de bombardement ionique, ce qui conduit à une transformation physique de la surface, en l'occurence à une augmentation de la rugosité par effet de pulvérisation. Un tel traitement peut conduire à la création de défauts dans la surface traitée.
   Les précurseurs gazeux employés pour le traitement plasma sont des précurseurs gazeux neutres ou réactifs, tels que Aᵣ, H₂, N₂, O₂, N₂O, SiH₄, ainsi que les combinaisons ou mélanges de ces éléments. On emploiera principalement H₂, N₂, O₂, N₂O, ainsi que SiH₄ qui permettent de produire des atomes ou des radicaux capables de modifier l'énergie de surface avec une gamme d'effets très étendue.
b) la détermination de l'énergie de surface de la surface prétraitée.
   Le prétraitement par plasma conduit à une modification globale de l'énergie de surface portant sur les composantes polaire et apolaire de celle-ci que l'on peut contrôler pour un éventuel réglage du procédé pour optimiser le traitement plasma. Plusieurs méthodes connues de détermination des composantes de l'énergie de surface peuvent être mises en oeuvre. On préfère néanmoins la méthode consistant à mesurer l'angle de contact d'une goutte de liquide avec la surface traitée qui comporte les avantages d'être une méthode simple et sensible, non destructive, qui permet une rétroaction rapide pour le réglage du procédé. En pratique, on réalise généralement l'expérience avec deux liquides et l'on mesure ainsi deux valeurs d'angle qui correspondent aux deux composantes polaire et apolaire de l'énergie de surface. On obtient ainsi plus d'information sur l'évolution physique de la surface. Comme liquide, on peut par exemple utiliser de l'eau pour déterminer l'évolution de la composante polaire et le diiodométhane pour déterminer l'évolution de la composante apolaire.
c) la réitération éventuelle de l'étape a) suivant les résultats obtenus dans l'étape b) en vue d'optimiser le traitement de surface.

Selon le procédé de l'invention, on peut réaliser plusieurs boucles de traitement de surface (traitement plasma + mesure d'angle de contact + réglagc du procédé + traitement plasma + mesure d'angle de contact + ... ) lors de l'étude proprement dite conduisant à la mise au point du procédé. Une fois cette étape réalisée, et après avoir vérifié la reproductibilité du traitement, le procédé de traitement de surface peut être utilisé dans une filière de fabrication de circuit. Ces boucles de réglage peuvent alors être omises ou être intégrées au procédé industriel.

Comme indiqué précédemment, une mise en oeuvre préférentielle du procédé de traitement de l'invention consiste à réaliser un dépôt après l'étape de traitement de surface. Ce dépôt peut être de nature différente. Il peut s'agir du dépôt d'un matériau métallique en vue de l'établissement d'interconnexion dans les vias d'un circuit intégré, du dépôt de polymères déposés par plasma ou de polysiloxanes en solution du type "spin on glass" ainsi que de tout autre dépôt d'un diélectrique, notamment en vue du remplissage de tranchées et/ou de l'aplanissement dans des techniques d'isolation latérale par tranchées de type BOX ou d'isolation intermétallique ou de tout autre structure réalisant des fonctions similaires.

On peut noter que dans le cas d'un dépôt SOG, l'intérêt de ce type de traitement plasma est aussi de transformer ce polymère en un matériau proche de l'oxyde de silicium.

L'étape de dépôt peut être constituée par le dépôt d'une seule couche sur la surface traitée ou de plusieurs couches. Lorsque l'étape de dépôt comprend le dépôt de plusieurs couches, on réitère l'étape de traitement de surface avant le dépôt de chacune des couches sur la couche sous-jacente de base ou sur la couche sous-jacente déposée selon le procédé de l'invention.

Le procédé de l'invention est avantageusement mis en oeuvre lorsque l'on effectue le dépôt d'une multicouche. En effet, cette mise en oeuvre de l'invention permet d'éviter la répercution des défauts morphologiques d'une couche à l'autre, défauts qui, en s'additionnant, diminuent considérablement la qualité du dépôt tant du point de vue de ses caractéristiques morphologiques et physiques que du point de vue de ses caractéristiques électriques.

Le procédé de traitement comprenant outre le traitement de surface, l'étape de dépôt d'un diélectrique, constitue l'un des modes de réalisation de l'invention. Il s'avère que ce mode de réalisation conduit à d'excellents résultats et notamment à la disparition de défauts morphologiques du dépôt effectué en maintenant, voire en améliorant les caractéristiques électriques du matériau.

L'étape de traitement de surface précédent l'étape de dépôt, peut être effectuée in situ au sein d'un même réacteur auquel cas elle est spécifique et indissociable de l'étape de dépôt.

Selon un autre mode de réalisation de l'invention, on peut effectuer des traitements de surface selon l'invention, ex situ, par exemple pour transformer une couche de SOG en une matériau proche de SiO₂ sans que celui-ci soit nécessairement suivi d'un dépôt ultérieur. Il est également possible de passiver la surface d'un dépôt, par exemple de type d'oxyde aplanissant, effectué dans une machine différente. En règle générale, le traitement in situ possède l'avantage important d'éviter certaines modifications indésirables (oxydation, pollution, etc...) de la surface. Celles-ci pourraient, dans certains cas, faire disparaître tout bénéfice apporté par le procédé.

Le procédé de traitement de l'invention peut être réalisé dans des réacteurs tels que ceux utilisés dans les machines de dépôt par CVD plasma, par exemple du type diode planaire RF. On préfère néanmoins réaliser le traitement dans des réacteurs plasma plus récents, comme par exemple des sources basse pression à haute densité de plasma de type DECR ou ECR (par exemple Lam) ou encore de type "couplage inductif" de type "HDP Applied Materiels", TCP Lam, avec ou sans confinement du plasma qui permettent une polarisation indépendante.

Le dépôt d'un diélectrique, plus particulièrement de l'oxyde de silicium, effectué après le traitement de surface, peut être du type PECVD, SACVD, du type oxyde d'aplanissement "APL" (CVD de SiH₄ et de H₂O₂) ou encore de tout autre type CVD ou de CVD plasma utilisant des précurseurs organiques, organosiliciés ou à base de silane.

L'épaisseur de la couche déposée selon le procédé de l'invention, notamment la couche de diélectrique, peut varier de 200 nm environ à 600 nm environ pour une monocouche et peut atteindre environ 1100 nm pour une multicouche.

Lorsque le procédé de traitement de l'invention comprend le dépôt d'une multicouche de diélectrique, on dépose éventuellement en dernière couche une couche dite d'encapsulation d'une épaisseur suffisante pour protéger la structure multicouche diélectrique réalisée en bloquant l'évolution de la surface et en la rendant ainsi insensible aux interactions indésirables avec l'environnement (réoxydation à l'atmosphère, pollution, ...). L'épaisseur typique d'une telle couche est comprise entre 100 nm et 300 nm.

On a vu précédemment qu'il était possible d'optimiser le traitement de surface par plasma, en fonction des composantes polaire et apolaire de l'énergie de surface déterminées après le traitement à partir de différentes mesures d'angle de contact en utilisant des liquides appropriés. La caractérisation du dépôt effectué ensuite donne des indications sur l'effet du traitement effectué sur le matériau déposé. On peut par exemple déterminer les caractéristiques morphologiques du dépôt par microscopie à balayage. En effectuant une étude paramétrique, il est donc possible de régler les conditions du traitement de surface par plasma en vue de l'énergie de surface recherchée pour une meilleure qualité du dépôt, notamment du point de vue de sa structure et de son adhésion à la surface. On peut compléter ces analyses par des mesures de contrainte mécaniques ainsi que des analyses physico-chimiques fines de la surface (XPS, AFM, PEELS, etc...).

En vue d'illustrer la technique de l'invention, deux exemples non limitatifs sont exposés ci-après :

### Exemple I. Augmentation de la mouillabilité par greffage d'atomes d'azote d'une surface d'oxyde thermique ou d'oxyde de silicium déposé par CVD ou CVD plasma.

Le traitement d'une surface d'oxyde de silicium thermique ou déposé par CVD ou CVD plasma, est réalisé dans un réacteur RF planaire de type ET Planar 200 sous plasma d'oxyde d'azote à moyenne pression de 600 mTorr (avec un débit de 500 Sccm) à une puissance RF de 300 W pendant une durée inférieure à 2 minutes.

Après cette étape de prétraitement, on détermine l'évolution de l'angle de contact avec un liquide polaire : l'eau, et un liquide apolaire : le diiodométhane.

Le prétraitement par plasma est ensuite réitéré dans les mêmes conditions utilisant cette fois-ci un plasma d'oxygène.

Une nouvelle mesure de l'angle de contact est effectuée.

L'évolution de l'angle de contact (en degrés) est représentée dans le tableau ci-dessous.

| Angle de contact | Liquide utilisé | |
|---|---|---|
| Type de traitement | eau | diiodo |
| Surface non traitée | 33 | 37 |
| Traitement par plasma de N₂O | 29 | 43 |
| Traitement par plasma de O₂ | 31 | 46 |

On note une évolution significative de l'angle de contact avec le diiodométhane. Celle-ci indique une augmentation de la composante apolaire de l'énergie de surface alors que la composante polaire varie faiblement. Le traitement de surface effectué modifie donc la chimie de la surface.

### Exemple II. Isolation latérale par tranchées de type BOX d'une surface présentant une marche semi-infinie, des motifs de largeur variable et des motifs de largeur fixe.

Après réoxydation du silicium dans les tranchées réalisées au sein du substrat semi-conducteur jusqu'à une épaisseur de couche d'environ 25 nm, la surface d'oxyde thermique est traitée par plasma froid N₂O à une pression moyenne d'environ 600 mTorr avec un débit de 500 cc/minute et une puissance RF de 300 W, pendant 30 secondes.

Sur la sous-couche d'oxyde thermique ainsi traitée, on dépose par CVD plasma modifié à pression réduite de 300 mTorr d'une durée d'environ 30 secondes, une couche de dioxyde de silicium d'une épaisseur comprise entre 100 à 200 nm.

Après cette étape de dépôt, on réitère l'étape de traitement par plasma N₂O dans les mêmes conditions que précédemment.

Sur la surface d'oxyde PECVD ainsi traitée, on dépose par CVD une couche d'oxyde aplanissant de type APL effectuée en deux ou trois séquences d'environ 20 secondes, d'une épaisseur totale de l'ordre de 600 nm. Le dépôt est effectué en deux ou trois séquences afin d'augmenter l'uniformité et le taux d'aplanissement du dépôt.

La surface de la couche APL est ensuite traitée par plasma froid O₂ pendant environ 120 secondes, les conditions de pression et de puissance étant les mêmes que pour le traitement de plasma N₂O précédent.

Cette étape de traitement par plasma O₂ est suivie d'une deuxième étape de traitement par plasma N₂O identique aux précédentes.

Sur la surface de l'oxyde d'aplanissement, on dépose ensuite par CVD plasma une couche de dioxyde de silicium à pression réduite pendant une durée d'environ 40 secondes pour obtenir une épaisseur typique de l'ordre de 300 nm. Cette dernière couche sert de couche d'encapsulation.

Dans les conditions de ce procédé, on obtient une tricouche isolante d'une épaisseur maximale de l'ordre de 1100 à 1200 nm. Ce dépôt est exempt de défauts morphologiques et on observe un degré d'aplanissement nettement augmenté atteignant des valeurs élevées. En effet, le taux d'aplanissement sur la marche semi-infinie est de l'ordre de 75%.

## Revendications

1. Procédé de traitement d'un substrat semi-conducteur, caractérisé en ce qu'il comprend préalablement une étape de traitement de surface comprenant les étapes suivantes :
a) le prétraitement de la surface par un plasma, à moyenne ou basse pression;
b) la détermination de l'énergie de surface de la surface ainsi traitée; et
c) la réitération éventuelle de l'étape a) suivant les résultats obtenus dans l'étape b).

2. Procédé selon la revendication 1, caractérisé en ce que l'on utilise pour le plasma des précurseurs gazeux choisis parmi H₂, N₂, Ar, O₂, N₂O et SiH₄, ainsi que les mélanges de ces gaz.

3. Procédé selon la revendication 1 ou 2, caractérisé en ce que l'on effectue l'étape a) dans un réacteur à forte densité plasma instaurant une concentration en électrons nₑ ≥ 10¹¹ cm⁻³.

4. Procédé selon l'une quelconque des revendications 1 à 3, caractérisé en ce que la différence de potentiel établie dans la source plasma lors du prétraitement de l'étape a) est faible, de l'ordre de Vₚ - V_{f} < 20 V.

5. Procédé selon l'une quelconque des revendications 1 à 4, caractérisé en ce que dans l'étape b), l'énergie de surface est déterminée par mesure de l'angle de contact d'une goutte de liquide avec la surface traitée.

6. Procédé selon l'une quelconque des revendications 1 à 5, caractérisé en ce que la surface traitée n'est pas plane.

7. Procédé selon la revendication 6, caractérisé en ce que la surface traitée présente localement des facteurs de forme compris entre 2 et 6.

8. Procédé selon l'une quelconque des revendications 1 à 7, caractérisé en ce qu'il comprend en outre au moins une étape de dépôt ultérieur d'un matériau diélectrique ou conducteur.

9. Procédé selon la revendication 8, caractérisé en ce qu'il comprend plusieurs étapes de dépôt séparées l'une de l'autre par réitération de l'étape de traitement définie dans la revendication 1.

10. Procédé selon la revendication 8 ou 9, caractérisé en ce que l'étape préalable de traitement de surface et l'étape de dépôt sur la surface traitée sont réalisées au sein d'un même réacteur.

11. Procédé selon l'une quelconque des revendications 8 à 10, caractérisé en ce que le matériau déposé sur la surface traitée est un diélectrique en vue de l'isolation latérale par tranchées de futures zones actives du substrat semi-conducteur ou en vue de l'isolation intermétallique.

12. Procédé selon l'une quelconque des revendications 8 à 10, caractérisé en ce que le matériau déposé sur la surface traitée est un matériau conducteur en vue de l'établissement d'interconnexions au sein du substrat semi-conducteur.

13. Procédé selon l'une quelconque des revendications 8 à 10, caractérisé en ce que le matériau de la surface à traiter est choisi parmi l'oxyde de silicium déposé par CVD ou PECVD, un oxyde thermique, les polymères déposés par plasma et des polysiloxanes en solution du type SOG.

14. Procédé selon l'une quelconque des revendications 1 à 11, caractérisé en ce qu'il comprend la succession des étapes suivantes :
1. le traitement de surface préalable par plasma N₂O tel que défini dans les étapes a) à c), effectué sur un oxyde thermique formé dans les tranchées réalisées au sein du substrat semi-conducteur;
2. le dépôt par PECVD à pression réduite d'une première couche d'oxyde de silicium;
3. la réitération de l'étape 1;
4. le dépôt par CVD d'une couche d'oxyde d'aplanissement;
5. le traitement de surface par plasma O₂ tel que défini dans les étapes a) à c);
6. la réitération de l'étape 1; et
7. le dépôt par PECVD à pression réduite d'une couche d'oxyde de silicium dite d'encapsulation, d'une durée supérieure à celle de l'étape 2.
